Europäisches Patentamt

European Patent Office

Office européen des brevets

Publication number: **0 282 704**
**A2**

# EUROPEAN PATENT APPLICATION

Application number: 88101169.6

Date of filing: 27.01.88

Int. Cl.⁴ **H01L 21/00** , H01L 21 312 ,
H01L 21/428

Priority: **20.03.87 JP 63980/87**

Date of publication of application:
**21.09.88 Bulletin 88/38**

Designated Contracting States:
**DE GB NL**

Applicant: **USHIO DENKI KABUSHIKI KAISHA**
**Asahi-Tokai Building 19-Floor No. 6-1,**
**Ote-machi 2-chome Chiyoda-ku**
**Tokyo, 100(JP)**

Inventor: **Arai, Tetsuji c/o USHIO DENKI**
**6409 Motoishikawa-cho Midori-ku**
**Yokohama-shi Kanagawa(JP)**

Representative: **Betten, Jürgen, Dipl.-Ing.**
**Patentanwälte Betten & Resch**
**Reichenbachstrasse 19**
**D-8000 München 5(DE)**

## Method of treating photoresists.

A method of treating positive photoresist materials applied on a semiconductor wafer placed on a support, which meets the demand for high-speed treatment and improvement in heat-resistance and etching-resistance of the developed positive photoresist image. The semiconductor wafer is heated by being exposed to radiant lights from a lamp such as a high pressure mercury vapor lamp radiating lights containing wavelengths of 350nm or below in a chamber filled with gas of lower pressure than 1 atmospheric pressure. While the semiconductor wafer is placed on the support, the speed to raise the temperature of the semiconductor wafer is controlled by exchanging the support for another with the different thickness.

FIG. I

## METHOD OF TREATING PHOTORESISTS

### Background of the Invention

1.Field of the Invention

This invention relates to a method of treating photoresist materials applied on semiconductor wafer placed on a support and, more particularly, to a method of treating the photoresist materials employing radiant light from a lamp such as a high pressure mercury vapor lamp.

2.Description of the prior Art

In the manufacture of semiconductor chips, a process of forming photoresist image is executed in the sequence of the application of photoresist materials, prebaking, exposure, development and postbaking, when roughly divided. Thereafter, ion implantation, or plasma-etching of a silicon oxide film, a silicon nitride film, an aluminum thin film and so on, which are formed beforehand on the surface of a semiconductor wafer prior to the application of those photoresist materials, is executed by using the photoresist image. After these processes those photoresist materials are removed from the semiconductor wafer.

Photoresist materials of high resolution has been used in recent years as semiconductor chips are high integrated and made highly fine. In this case, those photoresist materials show a tendency to be inferior in the heat-resistance. And another problem is lack of durability of photoresist materials("film erosion" etc.) in the process of etching.

With a view to enhancing the heat-resistance and the etching-resistance of photoresist materials, examinations and studies are made on a method in which a photoresist material is heated gradually to an elevated temperature for a sufficient time in postbaking, and method in which ultraviolet radiation are applied to photoresist image after development thereof or in postbaking. These methods are described in a reference of H. Hiraoka and J. Pacansky:J.Vac, Sci. Tech.19(1981), and U.S. Application No.923,504, and U.S Application No.923,553. However, the former method has a fault that it fails to ensure satisfactory heat-resistance and etching-resistance and requires to expose the photoresist materials to ultraviolet radiation for a considerably long time. The latter method, on the other hand, has a fault that, in case of employing a lamp such as a small pressure mercury vapor lamp mainly radiating ultraviolet rays results in an insufficient improvement in the etching-resistance and requires a considerably long exposure time.

And the latter method has another fault that, in case of employing a lamp such as a high pressure mercury vapor lamp radiating ultraviolet rays of higher intensity, although it doesn't necessitate a long exposure time, the temperature of a semiconductor wafer is elevated too highly because of radiant lights of high intensity and deformation or breakdown of photoresist image is caused.

As described above, the prior-art methods for particular treatments of photoresist materials employing ultraviolet radiation after development thereof or in postbaking have left unsettled the problems that a long exposure time for ultraviolet radiation is required for the treatment or that the temperature of a semiconductor wafer is elevated too highly because of radiant lights of high intensity and deformation or breakdown of photoresist image is caused, though they have been able to achieve some improvements in the heat-resistance and the etching-resistance.

### Summary of the Invention

An object of this invention is to keep the temperature of a semiconductor wafer from being elevated over the heat-resistance temperature of photoresist and to perform the high-speed and effective treatment of the developed positive photoresist image.

This invention provides a method of treating photoresist materials applied on a semiconductor wafer placed on a support, which meets the demand for high-speed treatment and improvement in heat-resistance and etching-resistance of the developed positive photoresist image. The semiconductor wafer is exposed to radiant lights from a lamp radiating lights containing wavelengths of 350nm or blow, which comprises heating the semiconductor wafer by exposing to radiant lights from the lamp under a small pressure and controlling the speed to raise the temperature of the semiconductor wafer while the semiconductor wafer is placed on the support.

Therefore, this invention makes it possible to treat developed positive photoresist image by employing ultraviolet radiation at shorter times for the reason that those photoresist materials is heated by radiant lights from the lamp, too in a chamber filled with gas of lower pressure than 1 atmospheric pressure. And the temperature of a semiconductor wafer is kept from being elevated over the heat-resistance temperature of positive photoresist by controlling the speed to raise the temperature of the semiconductor wafer.

## Brief Description of the Drawings

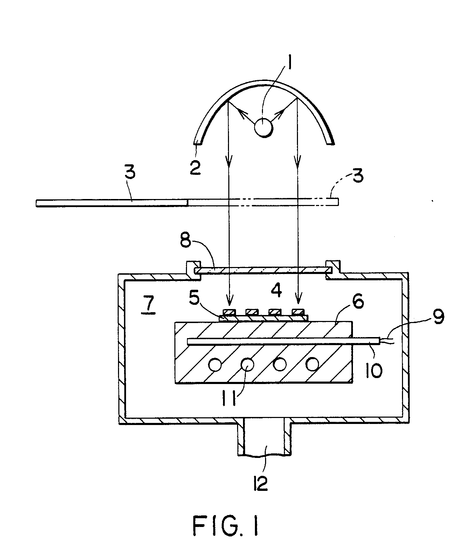

Fig.1 shows an embodiment of an apparatus for executing method for treatments of the developed positive photoresist image on a wafer according to this inven tion.

## Description of the Preferred Embodiment

A preferred embodiment of the invention will be described hereinafter with reference to the accompanying drawings.

An image is formed on a positive photoresist 4 which is coated on a semiconductor wafer 5, which is placed on a support 6. The support 6 is heated by a heater 10 connected with power supply through a heater lead wire 9, or cooled down by cooling water to flow through a cooling conduit 11. The temperature of the semiconductor wafer 5 is controlled by these heating and cooling mechanisms. Ultraviolet radiation source is composed of a high pressure mercury vapor lamp 1, a concave mirror 2, and a shutter 3 which can be opened and closed. Radiant lights containing ultraviolet rays, which are emitted from the high pressure mercury vapor lamp 1, are reflected by the concave mirror 2 and projected onto the developed positive photoresist image applied on the semiconductor wafer 5 through the shutter 3 and a window 8.

Next, a description will be made on a method of treating the developed positive photoresist image by using this apparatus. The semiconductor wafer 5, on which an image is formed, is placed on the support 6. The air the treating chamber 7 is exhausted by a vacuum pump through an exhaust hole 12 and the gas pressure becomes lower pressure than 1 atmospheric pressure after the semiconductor wafer 5 is placed on the support 6. The shutter 3 being opened in this state, the light emitted from the high pressure mercury vapor lamp 1 is projected onto the developed positive photoresist image. And the temperature of the support 6 is controlled, concretely explaining, the support 6 is heated by the heater 10 connected with power supply through the heater lead wire 9, or cooled down by cooling water to flow through the cooling conduit 11, and then the temperature of semiconductor wafer 5 placed on the support 6 is controlled too.

And it is possible that the temperature of the semiconductor wafer is controlled by changing the thickness of the support 6. As a suitable method of changing the thickness of the support 6. there is a method of replacing another one of different thickness for the support or a method of adding a metal plate to the support.

When the treatment of the positive photoresist image is ended. heating is stopped. the shutter 3 is closed, and the exposure to the ultraviolet radiation is stopped. Then, cooling water is flown through the cooling conduit 11 to cool the semiconductor wafer 5 down to a prescribed temperature. and the gas pressure in a chamber is returned to the normal atmospheric pressure and then the semiconductor wafer 5 can be removed from the support 6. After the treatment of the photoresist image on a wafer is completed, the above-described process may be repeated so as to treat the photoresist image on a next wafer in sequence.

In the above-mentioned embodiment, exposure time to treat said image by the ultraviolet radiation under lower atmospheric pressure is decreased by about 1/5 times in comparison with that under the air of 1 atmospheric pressure.

In the above-mentioned embodiment, in addition, the shutter is employed as a means to expose and stop exposing to radiant lights from the high pressure mercury vapor lamp. It is a matter of course that switching on and off of the high pressure mercury vapor lamp may be employed as a mean to expose or not.

And the concave mirror is employed as a means to select the composition of wavelengths of the lights to be exposed to the photoresist image. It is possible that a filter is employed instead of the mirror in order to select the wavelength of light.

And the high pressure mercury vapor lamp is employed as a means radiating ultraviolet lights containing suitable wavelengths. It is a matter of course that a lamp which contains a filling comprised of metal other than mercury in the form of halide may be employed.

## Claims

1.A method of treating a developed positive photoresist image which is applied on a semiconductor wafer placed on a support and exposed to radiant lights from a lamp radiating lights containing wavelengths of 350nm or below, which comprises heating the semiconductor wafer by exposing to radiant lights from the lamp in a chamber filled with gas of lower pressure than 1 atmospheric pressure and controlling the speed to raise the temperature of the semiconductor wafer while the semiconductor wafer is placed on the support.

2.A method according to claim 1 wherein the speed to raise the temperature of the semiconductor wafer is controlled by changing the thickness of the support.

3.A method according to claim 1 wherein the plate is provided with a heater and cooler.

4.A method according to claim 1 wherein the semiconductor wafer is arranged in a chamber filled with air of lower pressure than 1 atmospheric pressure.

FIG. I